# EUROPEAN PATENT APPLICATION

(11) **EP 4 345 906 A1**
(43) Date of publication of application: **03.04.2024**
(21) Application number: 23193167.6
(22) Date of filing: 24.08.2023
(51) Int. Cl.: H01L 29/06, H01L 29/08, H01L 29/161, H01L 29/165, H01L 29/423, H01L 29/66, H01L 29/775, B82Y 10/00, H01L 29/10

(54) **GATE-ALL-AROUND FIELD-EFFECT TRANSISTORS WITH SOURCE/DRAIN REGIONS HAVING DIFFERENT GERMANIUM CONCENTRATIONS**

(30) Priority: 23.09.2022 KR 20220120858
(71) Applicant: Samsung Electronics Co., Ltd., Suwon-si, Gyeonggi-do 16677 (KR)
(72) Inventor: CHO, Namkyu, Suwon-si, Gyeonggi-do 16677 (KR); KIM, Seokhoon, Suwon-si, Gyeonggi-do 16677 (KR); KIM, Jungtaek, Suwon-si, Gyeonggi-do 16677 (KR); PARK, Pankwi, Suwon-si, Gyeonggi-do 16677 (KR); JEONG, Seojin, Suwon-si, Gyeonggi-do 16677 (KR)
(74) Representative: Kuhnen & Wacker Patent- und Rechtsanwaltsbüro PartG mbB

(57) **Abstract**

A semiconductor device includes a substrate (101) including an active region (105) extending in a first direction (X), a gate structure (160) intersecting the active region (105) on the substrate (101) and extending in a second direction (Y), where the active region (105) includes a recessed region (RC) at at least one side of the gate structure (160), a plurality of channel layers (141, 142, 143, 144) on the active region (105), spaced apart from each other in a third direction (Z) that is substantially perpendicular to an upper surface of the substrate (101), and at least partially surrounded by the gate structure (160) and a source/drain region (150) in the recessed region (RC) of the active region (105) and connected to the plurality of channel layers (141, 142, 143, 144). The source/drain region (150) comprises a plurality of layers (152, 154, 156, 158) made of silicon-germanium, in which the content of Ge in the capping layer on the sidewalls of the channel layers (152) is higher than in the third layer (156).

## Description

### BACKGROUND

### 1. Field

One or more example embodiments of the disclosure relates to semiconductor devices.

### 2. Description of Related Art

With an increase in demand for high performance, high speed, and/or multifunctionality of semiconductor devices, integration density of semiconductor devices has been increasing. Due the tendency for high integration in semiconductor devices, in manufacturing semiconductor devices with a fine pattern, it may be necessary to implement patterns with fine widths or fine separation distances. In addition, efforts are being made to develop a semiconductor device including a fin field effect transistor (FinFET) with a three-dimensional channel in order to overcome the operating characteristics limitations due to the reduction of the size of a planar metal-oxide-semiconductor FET (MOSFET).

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide semiconductor devices having improved reliability.

One or more example embodiments provide a semiconductor device including a source/drain region having a plurality of semiconductor layers with different composition, and as a result, the semiconductor device may have improved reliability by preventing damage during a manufacturing process.

Additional aspects will be set forth in part in the description which follows and, in part, will be apparent from the description, or may be learned by practice of the presented embodiments.

According to an aspect of an example embodiment, a semiconductor device may include a substrate including an active region extending in a first direction, a gate structure intersecting the active region on the substrate and extending in a second direction, where the active region includes a recessed region at at least one side of the gate structure, a plurality of channel layers on the active region, spaced apart from each other in a third direction that is substantially perpendicular to an upper surface of the substrate, and at least partially surrounded by the gate structure and a source/drain region in the recessed region of the active region and connected to the plurality of channel layers, where the source/drain region may include a plurality of first semiconductor layers on the active region and on side surfaces of the plurality of channel layers that are exposed through the recessed region, the plurality of first semiconductor layers being spaced apart from each other, a second semiconductor layer extending continuously while being provided on at least one of the plurality of first semiconductor layers and side surfaces of the gate structure, and a third semiconductor layer on the second semiconductor layer, where the plurality of first semiconductor layers may include a first concentration of germanium (Ge) and where the third semiconductor layer may include a second concentration of germanium (Ge) that is smaller than the first concentration of germanium (Ge).

According to an aspect of an example embodiment, a semiconductor device may include a substrate including an active region extending in a first direction, a gate structure intersecting the active region on the substrate and extending in a second direction, where the active region may include a recessed region at at least one side of the gate structure, a plurality of channel layers on the active region, spaced apart from each other in a third direction that is substantially perpendicular to an upper surface of the substrate, and at least partially surrounded by the gate structure, and a source/drain region in the recessed region of the active region and connected to the plurality of channel layers, where the source/drain region may include a first semiconductor layer on the active region and side surfaces of the plurality of channel layers that are exposed through the recessed region, a second semiconductor layer on the first semiconductor layer and a third semiconductor layer on the second semiconductor layer, and where the first semiconductor layer may include a first concentration of germanium (Ge), the third semiconductor layer may include a second concentration of germanium (Ge) that is smaller than the first concentration of germanium (Ge), and the second semiconductor layer may include a third concentration of germanium (Ge) that is smaller than the second concentration of germanium (Ge).

According to an aspect of an example embodiment, a semiconductor device may include a substrate including an active region extending in a first direction, a gate structure intersecting the active region on the substrate and extending in a second direction, where the active region may include a recessed region at at least one side of the gate structure, a plurality of channel layers on the active region, spaced apart from each other in a third direction that is substantially perpendicular to an upper surface of the substrate, and at least partially surrounded by the gate structure, and a source/drain region in the recessed region of the active region and connected to the plurality of channel layers, where the source/drain region may include a plurality of first semiconductor layers on the active region and on side surfaces of the plurality of channel layers that are exposed through the recessed region, the plurality of first semiconductor layers being spaced apart from each other and including silicon germanium (SiGe) layers, a second semiconductor layer on at least one of the plurality of first semiconductor layers, the second semiconductor layer including a silicon (Si) layer, and a third semiconductor layer on the second semiconductor layer, the third semiconductor layer including a silicon germanium (SiGe) layer.

### BRIEF DESCRIPTION OF DRAWINGS

The above and other aspects, features, and advantages of certain example embodiments of the present disclosure will be more apparent from the following description taken in conjunction with the accompanying drawings, in which:
FIG 1 is a plan view illustrating a semiconductor device according to example embodiments;
FIG. 2 is a cross-sectional view illustrating a semiconductor device according to example embodiments;
FIG. 3 is an enlarged view of region 'A' of FIG. 2 according to example embodiments;
FIG. 4 is an enlarged view of region 'A' of FIG. 2 according to another example embodiment;
FIG. 5 is a cross-sectional view illustrating a semiconductor device according to example embodiments;
FIG. 6 is an enlarged view of region `A' of FIG. 5 according to example embodiments;
FIGS. 7A and 7B are partially enlarged views of a semiconductor device according to example embodiments;
FIG. 8 is a cross-sectional view of a semiconductor device according to example embodiments;
FIG. 9 is an enlarged view of region 'A' of FIG. 8 according to an example embodiment;
FIG. 10 is a plan view of a semiconductor device according to example embodiments;
FIG. 11 is a cross-sectional view of the semiconductor device of FIG. 10 taken along lines III-IIIʹ and IV-IV'according to example embodiments;
FIG. 12 is a cross-sectional view illustrating a semiconductor device according to example embodiments;
FIG. 13 is a flowchart illustrating a method for manufacturing a semiconductor device according to example embodiments; and
FIGS. 14A, 14B, 14C, 14D, 14E, 14F, 14G, 14H, 14I and 14J illustrate a method for manufacturing a semiconductor device according to a process sequence according to example embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

Terms such as 'on', an `upper portion', an `upper surface', 'under', a `lower portion', a `lower surface', and a `side surface' may be understood to be indicated based on the drawings, except in a case in which they are indicated by reference numerals and referred to separately.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

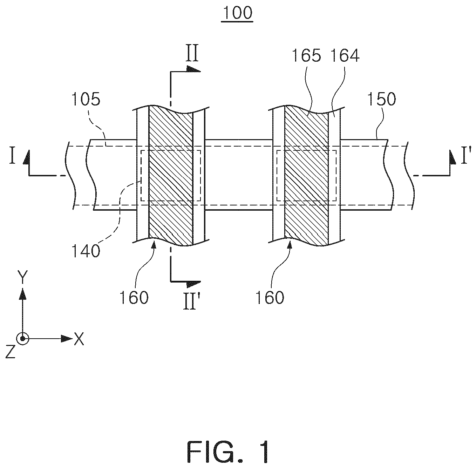

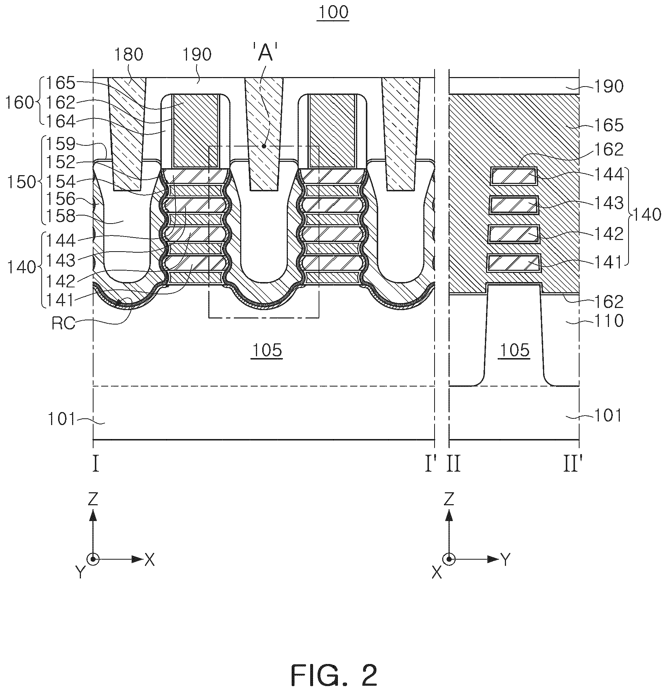

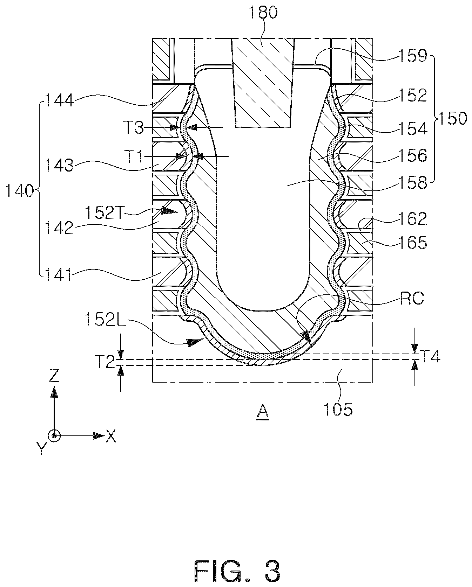

FIG. 1 is a plan view illustrating a semiconductor device according to example embodiments. FIG. 2 is a cross-sectional view illustrating a semiconductor device according to example embodiments. FIG. 2 illustrates cross-sections in which the semiconductor device of FIG. 1 is cut along lines I-I' and II-II'. FIG. 3 is an enlarged view of region 'A' of FIG. 2 according to example embodiments.

It is understood here that FIG. 1 is a plan view provided to show only the positional relationship between gate structures and source/drain regions on an active region in a semiconductor device of the present embodiments, and thus, the plan view may not show other elements of the semiconductor device shown in FIGS. 2 and 3.

Referring to FIGS. 1 to 3, a semiconductor device 100 may include a substrate 101 including an active region 105, channel structures 140 including first to fourth channel layers 141, 142, 143 and 144 spaced apart from each other vertically on the active region 105, gate structures 160 intersecting the active region 105 and including a gate electrode 165, respectively, source/drain regions 150 contacting the channel structures 140, and contact plugs 180 connected to the source/drain regions 150. The semiconductor device 100 may further include a device isolation layer 110, gate dielectric layers 162, gate spacer layers 164, and an interlayer insulating layer 190. Each of the source/drain regions 150 may include first semiconductor layers 152, a second semiconductor layer 154, a third semiconductor layer 156, a fourth semiconductor layer 158, and a fifth semiconductor layer 159.

In the semiconductor device 100, the active region 105 may have a fin structure, and the gate electrode 165 may be disposed between the active region 105 and the channel structure 140, between the first to fourth channel layers 141, 142, 143 and 144 of the channel structure 140, and on the channel structure 140. Accordingly, the semiconductor device 100 may include transistors having a multi-bridge channel field-effect transistor (FET) (MBCFET^{™}) structure, which is a gate-all-around type field effect transistor.

The substrate 101 may have an upper surface extending in an X-direction and a Y-direction. The substrate 101 may include a semiconductor material, for example, a group IV semiconductor, a group III-V compound semiconductor, or a group II-V compound semiconductor. For example, the IV group semiconductor may include silicon, germanium, or silicon-germanium. The substrate 101 may be provided as a bulk wafer, an epitaxial layer, a silicon-on-insulator (SOI) layer, or a semiconductor-on-insulator (SeOI) layer.

The substrate 101 may include an active region 105 disposed in an upper portion thereof. The active region 105 is defined by the device isolation layer 110 in the substrate 101 and may be disposed to extend in a first direction, for example, an X-direction. However, the active region 105 may be described as a separate configuration from the substrate 101. Since the active region 105 partially protrudes on the device isolation layer 110, an upper surface of the active region 105 may be disposed at a higher level than an upper surface of the device isolation layer 110. The active region 105 may be formed of a portion of the substrate 101 or may include an epitaxial layer grown from the substrate 101. However, in opposite sides of a gate structure 160, the active regions 105 may be partially recessed to form recessed regions RC, and source/drain regions 150 may be disposed in the recessed regions RC.

In example embodiments, the active region 105 may or may not include a well region including impurities. For example, for a p-type transistor (pFET), the well region may include n-type impurities such as phosphorus (P), arsenic (As), or antimony (Sb), and for an n-type transistor (nFET), the well region may include p-type impurities such as boron (B), gallium (Ga), or indium (In). The well region may be disposed, for example, at a predetermined depth from the upper surface of the active region 105.

The device isolation layer 110 may define an active region 105 in the substrate 101. The device isolation layer 110 may be formed by, for example, a shallow trench isolation (STI) process. The device isolation layer 110 may expose the upper surface of the active region 105 or may partially expose an upper portion thereof. In some embodiments, as the device isolation layer 110 is closer to the active region 105, it may have a curved upper surface to have a higher level. The device isolation layer 110 may be formed of an insulating material. The device isolation layer 110 may be, for example, an oxide, a nitride, or a combination thereof.

The gate structures 160 may be disposed on the active region 105 and the channel structures 140 and extend in a second direction, for example, a Y-direction, by intersecting the active region 105 and the channel structures 140. A functional channel region of the transistors may be formed in the active region 105 and/or the channel structures 140, which intersect the gate electrodes 165 of the gate structures 160. Each of the gate structures 160 may include a gate electrode 165, gate dielectric layers 162 between the gate electrode 165 and the first to fourth channel layers 141, 142, 143 and 144, and the gate spacer layers 164 on side surfaces of the gate electrode 165. In example embodiments, each of the gate structures 160 may further include a capping layer on an upper surface of the gate electrode 165. Alternatively, a portion of the interlayer insulating layer 190 on the gate structure 160 may be referred to as a gate capping layer.

The gate dielectric layers 162 may be disposed between the active region 105 and the gate electrode 165 and between the channel structure 140 and the gate electrode 165. The gate dielectric layers 162 may be disposed to cover (or at least partially cover) at least some of the surfaces of the gate electrode 165. For example, the gate dielectric layers 162 may be disposed to surround all surfaces except for an uppermost surface of the gate electrode 165. The gate dielectric layers 162 may extend between the gate electrode 165 and the gate spacer layers 164, but the present disclosure is not limited thereto. The gate dielectric layers 162 may include an oxide, a nitride, or a high-k material. The high-k material may refer to a dielectric material with a higher dielectric constant than that of a silicon oxide layer (SiOz). The high-k material may refer to a dielectric material with a higher dielectric constant than that of the silicon oxide (SiOz) film. The high-k material may be, for example, at least one of aluminum oxide (Al₂O₃), tantalum oxide (Ta₂O₃), titanium oxide (TiOz), yttrium oxide (Y₂O₃), zirconium oxide (ZrOz), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). According to embodiments, the gate dielectric layer 162 may be formed of a multilayer film.

The gate electrode 165 may be disposed to extend to the channel structure 140 while filling a gap between the first to fourth channel layers 141, 142, 143 and 144 on the active region 105. The gate electrode 165 may be spaced apart from the first to fourth channel layers 141, 142, 143 and 144 by the gate dielectric layers 162. The gate electrode 165 may include a conductive material, such as a metal nitride including a titanium nitride (TiN), a tantalum nitride (TaN), or a tungsten nitride (WN), and/or a metal material such as aluminum (Al), tungsten (W), or molybdenum (Mo), or a semiconductor material such as doped polysilicon. According to example embodiments, the gate electrode 165 may be formed of two or more multilayers.

The gate spacer layers 164 may be disposed on opposite side surfaces of the gate electrode 165 on the channel structure 140. The gate spacer layers 164 may insulate the source/drain regions 150 from the gate electrode 165. The gate spacer layers 164 may have a multilayer structure according to example embodiments. The gate spacer layers 164 may be formed of at least one of oxide, nitride, and oxynitride, for example, a low dielectric constant film.

The channel structures 140 may be disposed on the active region 105 in regions where the active region 105 intersects the gate structures 160. Each of the channel structures 140 may include the first to fourth channel layers 141, 142, 143 and 144, which are a plurality of channel layers spaced apart from each other in a third direction, for example, a Z-direction. The first to fourth channel layers 141, 142, 143 and 144 may be sequentially disposed from the active region 105. The channel structures 140 may be connected to the source/drain regions 150. The channel structures 140 may have a width equal to or similar to that of the gate structures 160 in the X-direction, and may have a width equal to or smaller than that of the active region 105 in the Y-direction. In the cross-section taken along the Y-direction, the channel layer disposed in a lower portion of the first to fourth channel layers 141, 142, 143 and 144 may have a width equal to or greater than that of the channel layer disposed in an upper portion.

The number and shape of channel layers constituting one channel structure 140 may be variously changed in some embodiments. For example, one channel structure 140 may include three channel layers or two or five or more channel layers. As illustrated in FIG. 2, the first to third channel layers 141, 142 and 143 may have side surfaces in the X-direction that are outwardly convex, and the uppermost fourth channel layer 144 may have side surfaces inclined so as to decrease a width thereof toward the active region 105. However, in some embodiments, shapes and relative widths of side surfaces of the first to fourth channel layers 141, 142, 143 and 144 may be variously changed, and are not limited to the shapes illustrated in FIG. 2. For example, in some embodiments, the first to fourth channel layers 141, 142, 143 and 144 may have side surfaces extending vertically in the Z-direction.

The channel structures 140 may be formed of a semiconductor material, and may include, for example, at least one of silicon (Si), silicon germanium (SiGe), and germanium (Ge). The channel structures 140 may be formed of, for example, the same material as the active region 105. In some embodiments, the channel structures 140 may include an impurity region disposed in a region adjacent to the source/drain regions 150.

The source/drain regions 150 may be disposed in the recessed regions RC in which upper portions of the active region 105 are partially recessed in opposite sides of the gate structure 160. The recessed regions RC may extend along side surfaces of the channel structures 140 and side surfaces of the gate dielectric layers 162. The source/drain regions 150 may be disposed to cover (or at least partially cover) side surfaces of each of the first to fourth channel layers 141, 142, 143 and 144 of the channel structures 140 in the X-direction. Upper surfaces of the source/drain regions 150 may be disposed on a level equal to or higher than lower surfaces of the gate electrodes 165 on the channel structures 140, and the level may be variously changed in some embodiments. Each of the source/drain regions 150 may include first semiconductor layers 152, a second semiconductor layer 154, a third semiconductor layer 156, a fourth semiconductor layer 158, and a fifth semiconductor layer 159. The first semiconductor layers 152, the second semiconductor layer 154, the third semiconductor layer 156, the fourth semiconductor layer 158, and the fifth semiconductor layer 159 may be epitaxial layers, respectively.

As illustrated in FIG. 3, the first semiconductor layers 152 may cover (or at least partially cover) side surfaces along the side surfaces of each of the first to fourth channel layers 141, 142, 143 and 144 exposed through the recessed region RC in the X-direction and the upper surface of the active region 105. The first semiconductor layers 152 may be spaced apart from each other on the side surfaces of each of the first to fourth channel layers 141, 142, 143 and 144 and the upper surface of the active region 105.

The first semiconductor layers 152 may have a substantially conformal thickness or a substantially uniform thickness. For example, when a region on the side surfaces of each of the first to fourth channel layers 141, 142, 143 and 144 of the first semiconductor layers 152 is referred to as upper layers 152T and a region on the upper surface of the active region 105 is referred to as a lower layer 152L, a thickness T1 of the upper layers 152T may be substantially the same as a thickness T2 of the lower layer 152L. The thicknesses T1 and T2 of the first semiconductor layers 152 may be in a range of about 0.1 nm to about 5 nm (e.g., in a range of about 0.1 nm to about 3 nm).

The upper layers 152T may be interposed between the first to fourth channel layers 141, 142, 143 and 144 and the second semiconductor layer 154, and the lower layer 152L may be interposed between the active region 105 and the second semiconductor layer 154. Inner surfaces of the recessed region RC may have inwardly concave regions in a region contacting the channel structure 140, and accordingly the upper layers 152T may also have a curved shape. Accordingly, at least portions of the ends of each of the upper layers 152T may be shifted in the X-direction without being disposed in a straight line in the Z-direction. A portion of the surfaces of the upper layers 152T, for example, upper and lower surfaces, may contact the gate dielectric layers 162, but the present disclosure is not limited thereto.

The second semiconductor layer 154 may be disposed on the first semiconductor layers 152 in the recessed region RC. Unlike the first semiconductor layers 152, the second semiconductor layer 154 may be a single layer, and may continuously extend along the side surfaces of the first semiconductor layers 152 and the side surfaces of the gate dielectric layers 162. The second semiconductor layer 154 may have inwardly concave regions on the side surfaces of the channel structure 140 and may have convex regions protruding outward in regions contacting the gate dielectric layers 162.

The second semiconductor layer 154 may have a substantially conformal thickness or a substantially uniform thickness. For example, a thickness T3 of the second semiconductor layer 154 on the side surface of the gate dielectric layer 162 may be substantially the same as a thickness T4 of the second semiconductor layer 154 on the active region 105. The thicknesses T3 and T4 of the second semiconductor layer 154 may be equal to or larger than the thicknesses T1 and T2 of the first semiconductor layers 152. The thicknesses T3 and T4 of the second semiconductor layer 154 may range, for example, from about 0.1 nm to about 5 nm.

The third semiconductor layer 156 may be disposed on the second semiconductor layer 154 in the recessed region RC. The third semiconductor layer 156 may have a relatively thick thickness on a bottom surface of the recessed region RC (i.e., on the active region 105), but the shape of the third semiconductor layer 156 is not limited thereto. An outer surface of the third semiconductor layer 156 may have curves along the second semiconductor layer 154, and an inner surface of the third semiconductor layer 156 may have a relatively relaxed curve or have no curve. The third semiconductor layer 156 may have a thickness greater than those of the first semiconductor layers 152 and the second semiconductor layer 154. The thickness of the third semiconductor layer 156 may range, for example, from about 0.5 nm to about 10 nm.

The fourth semiconductor layer 158 may be disposed on the third semiconductor layer 156 to fill the recessed region RC. An upper surface of the fourth semiconductor layer 158 may be disposed at a higher level than the upper surface of the channel structure 140, but the present disclosure is not limited thereto. The fourth semiconductor layer 158 may contact a lower end of a contact plug 180. The width of the fourth semiconductor layer 158 in the X-direction may range, for example, from about 10 nm to about 30 nm.

The fifth semiconductor layer 159 may be disposed on an upper surface of the fourth semiconductor layer 158. The fifth semiconductor layer 159 may have a thickness thinner than that of the fourth semiconductor layer 158. The fifth semiconductor layer 159 may have a thickness thinner than that of the third semiconductor layer 156, but the present disclosure is not limited thereto.

The source/drain regions 150 may include a semiconductor material. The semiconductor material may include, for example, at least one of silicon (Si) and germanium (Ge), and may further include impurities. For example, when the semiconductor device 100 is the pFET, the impurities may be at least one of boron (B), gallium (Ga), and indium (In).

The first semiconductor layers 152 may include silicon germanium (SiGe) and include germanium (Ge) in a first concentration. The first concentration may be in a range of about 1% to about 15% (e.g., in a range of about 7% to about 13%). The concentration of germanium (Ge) may refer to an atomic percentage.

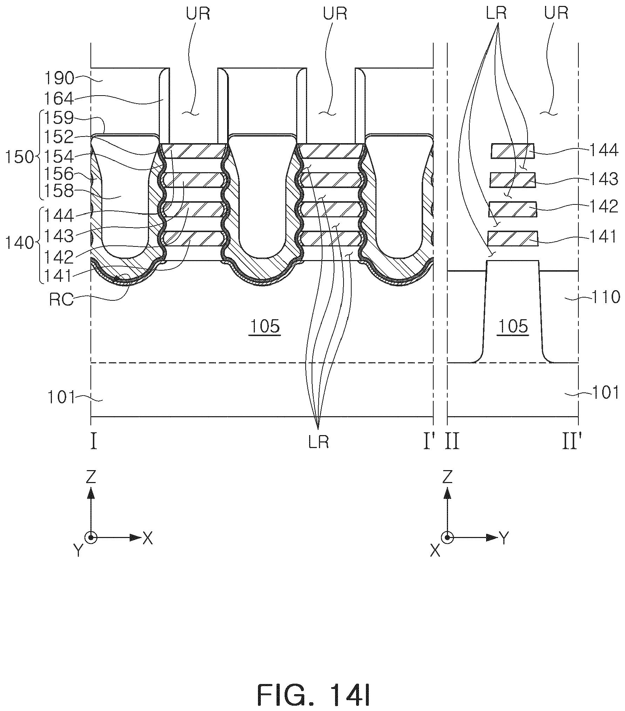

The second semiconductor layer 154 may include silicon (Si) and may not include germanium (Ge), or may include a portion of germanium (Ge) diffused from the first semiconductor layers 152 and the third semiconductor layer 156. The second semiconductor layer 154 may include germanium (Ge) in a second concentration smaller than the first concentration, and may include a case in which the second concentration is 0. The second concentration may be about 3% or less. Each of the source/drain regions 150 may include the second semiconductor layer 154, thereby preventing the third semiconductor layer 156 from being damaged during the manufacturing process. This will be described in more detail below with reference to FIG. 14I.

The third semiconductor layer 156 may include silicon germanium (SiGe), and may include germanium (Ge) in a third concentration smaller than the first concentration and larger than the second concentration. The third concentration may be in a range of about 2% to about 9% (e.g., in a range of about 4% to about 7%). The fourth semiconductor layer 158 may include silicon germanium (SiGe), and germanium (Ge) may be included in a fourth concentration greater than the first concentration and the third concentration. The fourth concentration may be about 30% or more (e.g., in the range of about 40% to about 70%). The fifth semiconductor layer 159 may contain silicon (Si) and may not include germanium (Ge), or may include a fifth concentration of germanium (Ge) having a relatively low concentration. The fifth concentration may be smaller than the fourth concentration, and in some embodiments, may be smaller than the third concentration.

For example, the first semiconductor layers 152, the third semiconductor layer 156, and the fourth semiconductor layer 158 may be silicon germanium (SiGe) layers, and the second semiconductor layer 154 and the fifth semiconductor layer 159 may be silicon (Si) layers.

The interlayer insulating layer 190 may be disposed to cover (or at least partially cover) the source/drain regions 150 and the gate structure 160 and to cover (or at least partially cover) the device isolation layer 110. The interlayer insulating layer 190 may include at least one of oxide, nitride, and oxynitride, and may include, for example, a low dielectric constant material. According to example embodiments, the interlayer insulating layer 190 may include a plurality of insulating layers.

The contact plugs 180 may penetrate the interlayer insulating layer 190 and be connected to the source/drain regions 150, and may apply an electrical signal to the source/drain regions 150. The contact plugs 180 may have inclined side surfaces in which a width of a lower portion becomes narrower than a width of an upper portion according to an aspect ratio, but the present disclosure not limited thereto. The contact plugs 180 may extend downwardly from the top (e.g., below the lower surface of the fourth channel layer 144 in the uppermost portion of the channel structure 140), but the present disclosure is not limited thereto. The contact plugs 180 may contact the fourth semiconductor layers 158 of the source/drain regions 150, and may be spaced apart from the first semiconductor layers 152 and the second semiconductor layer 154. In some embodiments, the contact plugs 180 may be disposed to be in contact along an upper surface of the source/drain regions 150 without recessing the source/drain regions 150.

Each of the contact plugs 180 may include a metal silicide layer disposed at a lower end including a lower surface, and may further include a barrier layer forming side surfaces of the contact plug 180 and extending to an upper surface of the metal silicide layer. The barrier layer may include, for example, a metal nitride such as a titanium nitride (TiN), a tantalum nitride (TaN), or a tungsten nitride (WN). The contact plugs 180 may include, for example, a metal material such as aluminum (Al), tungsten (W), or molybdenum (Mo). In example embodiments, the number and arrangement of conductive layers constituting the contact plugs 180 may be variously changed.

An interconnection structure such as a contact plug may be further disposed on the gate electrode 165, and an interconnection structure connected to the contact plugs 180 may be further disposed on the contact plugs 180.

The following description of example embodiments may include features similar to those described with respect to FIGS. 1-3, and repeated descriptions may be omitted.

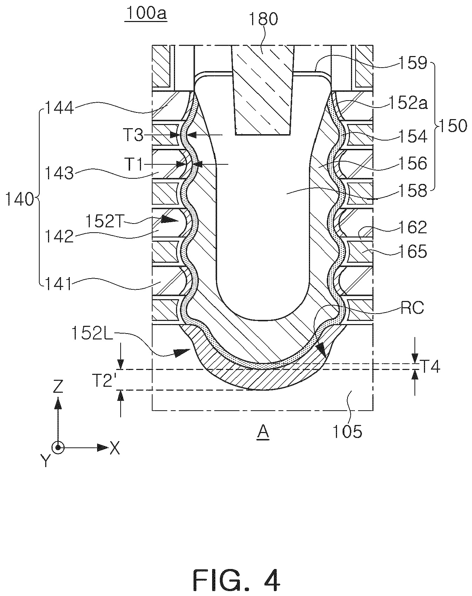

FIG. 4 is an enlarged view of region 'A' of FIG. 2 according to another example embodiment.

Referring to FIG. 4, in the semiconductor device 100a, first semiconductor layers 152a of the source/drain region 150 may have a non-uniform thickness. Specifically, a thickness T2' of the lower layer 152L on the upper surface of the active region 105 may be greater than the thickness T1 of the upper layers 152T on the side surfaces of the channel structure 140. Such a structure may be formed when the growth rate of the first semiconductor layer 152a is relatively high on the active region 105 according to process conditions at the time of forming the first semiconductor layers 152a. In example embodiments, a relative thickness difference between the lower layer 152L and the upper layers 152T may be variously changed.

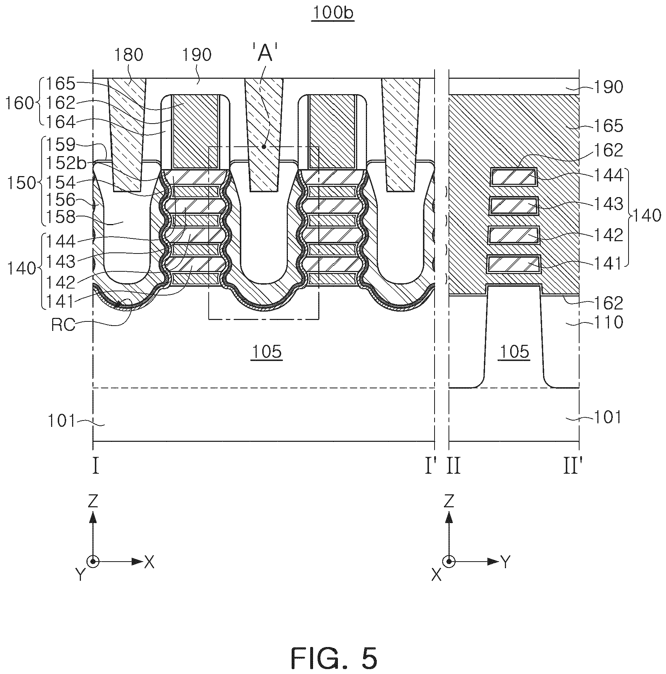

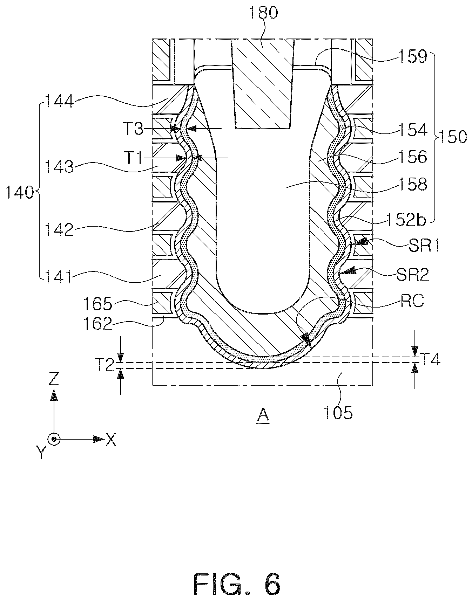

FIG. 5 is a cross-sectional view illustrating a semiconductor device according to example embodiments. FIG. 6 is an enlarged view of region 'A' of FIG. 5 according to example embodiments.

Referring to FIGS. 5 and 6, in a semiconductor device 100b, the source/drain region 150 may include a first semiconductor layer 152b that is a single layer. In the source/drain region 150, the first semiconductor layer 152b may be disposed as a single layer. The first semiconductor layer 152b may cover (or at least partially cover) side surfaces of each of the first to fourth channel layers 141, 142, 143 and 144 in the X-direction, may cover (or at least partially cover) side surfaces of the gate dielectric layers 162 under the channel structure 140, and may extend to an upper surface of the active region 105.

The first semiconductor layer 152b may contact the gate dielectric layers 162, and may include convex regions protruding outward toward the gate dielectric layers 162 in regions SR1 contacting the gate dielectric layers 162. The first semiconductor layer 152b may have an inwardly concave shape in regions SR2 in contacting the channel structure 140. In the example embodiment, the first semiconductor layer 152b may have a profile similar to the second semiconductor layer 154, and the second semiconductor layer 154 may extend along the first semiconductor layer 152b.

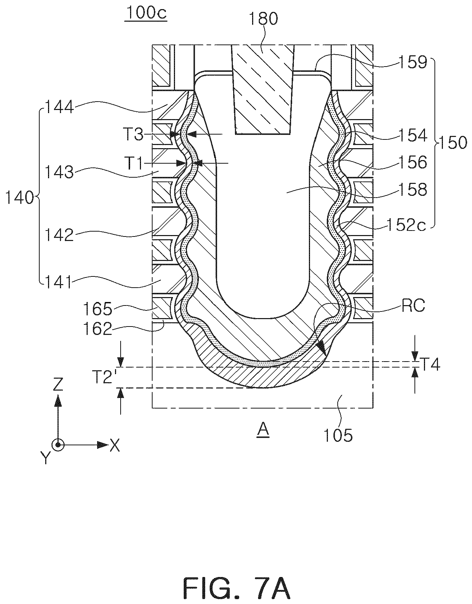

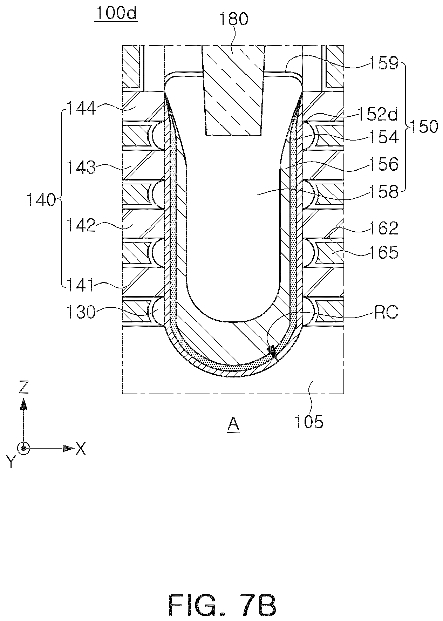

FIGS. 7A and 7B are partially enlarged views of a semiconductor device according to example embodiments. FIGS. 7A and 7B illustrate regions corresponding to FIG. 6.

Referring to FIG. 7A, in the semiconductor device 100c, the first semiconductor layer 152c of the source/drain region 150 may have a non-uniform thickness. Specifically, the thickness T2' of the first semiconductor layer 152c on the upper surface of the active region 105 may be larger than the thickness T1 of the first semiconductor layer 152c on the side surfaces of the channel structure 140. Similarly to the embodiment of FIG. 4, such a structure may be formed when the first semiconductor layer 152c has a relatively high growth rate on the active region 105 according to process conditions when the first semiconductor layers 152c are formed.

Referring to FIG. 7B, a semiconductor device 100d may further include inner spacer layers 130 disposed on opposite side surfaces in the X-direction of the gate structure 160 under the fourth channel layer 144.

The inner spacer layers 130 may be disposed in parallel with the gate electrodes 165 and the gate dielectric layers 162 between the first to fourth channel layers 141, 142, 143 and 144 in the Z-direction. The gate electrodes 165 may be stably spaced apart from the source/drain regions 150 by the inner spacer layers 130 and may be electrically separated. The inner spacer layers 130 may have a shape in which side surfaces facing the gate electrodes 165 are convexly rounded inward toward the gate electrodes 165, but the present disclosure is not limited thereto. The inner spacer layers 130 may be formed of at least one of oxide, nitride, and oxynitride, and may include, for example, a low dielectric constant film. In some embodiments, the semiconductor device 100d may include a plurality of devices, and the inner spacer layers 130 may be applied only to some of the devices.

In the source/drain region 150, the first semiconductor layer 152d may be disposed as a single layer as in the embodiments of FIGS. 5 and 6. The first semiconductor layer 152d may have regions contacting the inner spacer layers 130. Due to the inner spacer layers 130, the side surfaces of the first semiconductor layer 152d may not have curves or may have a shape in which the curves are relaxed, unlike the embodiments of FIGS. 5 and 6. Accordingly, the second semiconductor layer 154 may also have a surface that has no curve or a relaxed curve.

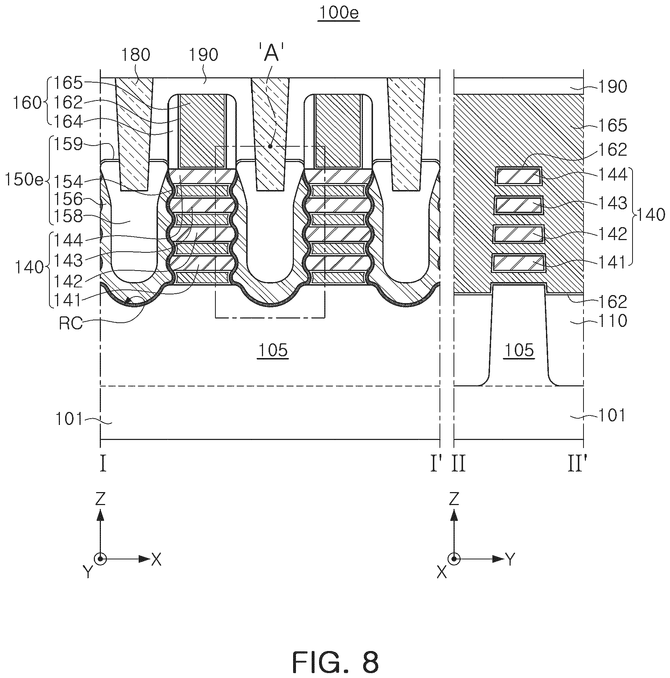

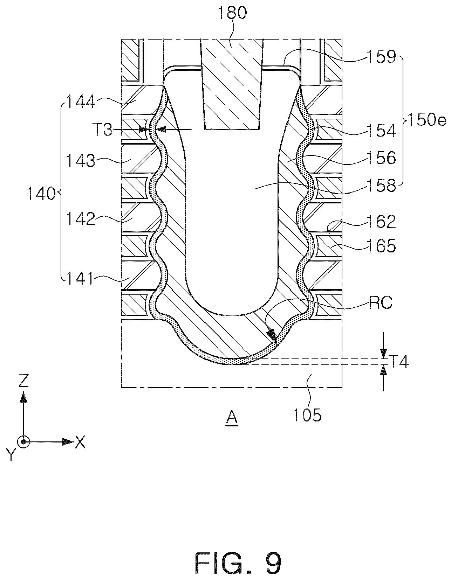

FIG. 8 is a cross-sectional view and a partially enlarged view of a semiconductor device according to example embodiments. FIG. 9 is an enlarged view of region `A' of FIG. 8 according to an example embodiment.

Referring to FIGS. 8 and 9, in a semiconductor device 100e, the source/drain region 150e may not include the first semiconductor layer 152 of the embodiments of FIGS. 2 and 3. The source/drain region 150e may include only the second semiconductor layer 154, the third semiconductor layer 156, the fourth semiconductor layer 158, and the fifth semiconductor layer 159. Accordingly, the second semiconductor layer 154 may be disposed on the inner surface of the recessed region RC and may extend to cover (or at least partially cover) the side surface of each of the first to fourth channel layers 141, 142, 143 and 144 exposed through the recessed region RC in the X-direction and the upper surface of the active region 105.

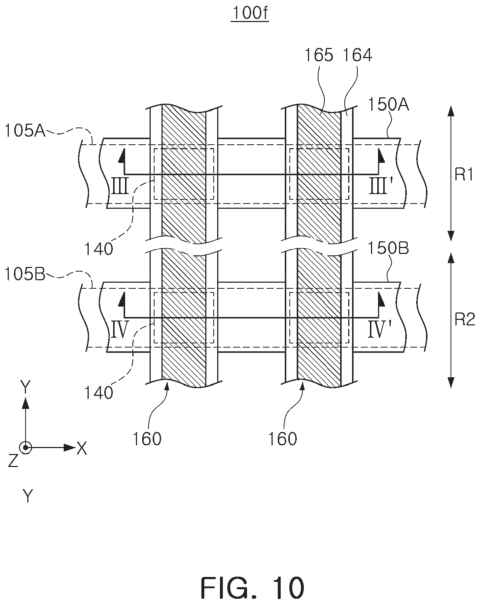

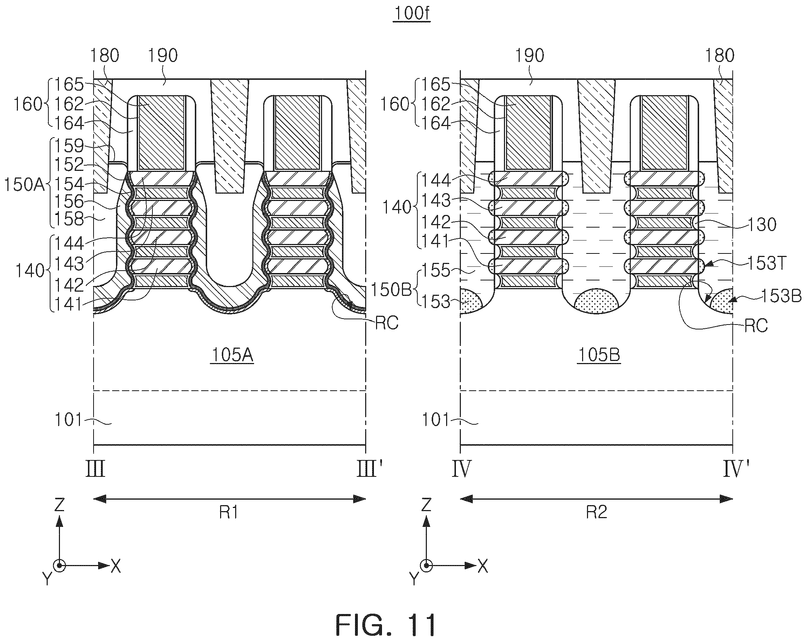

FIG. 10 is a plan view of a semiconductor device according to example embodiments. FIG. 11 is a cross-sectional view of the semiconductor device of FIG. 10 taken along lines III-IIIʹ and IV-IV'according to example embodiments. For convenience of description, FIG. 10 illustrates only some components of the semiconductor device 100f.

Referring to FIGS. 10 and 11, a semiconductor device 100f may include first and second regions R1 and R2, and may further include inner spacer layers 130 disposed in the second region R2. The first and second regions R1 and R2 may be regions adjacent to each other or spaced apart from each other. A first active region 105A and first source/drain regions 150A may be disposed in the first region R1, and a second active region 105B and second source/drain regions 150B may be disposed in the second region R2. Other components including the gate structures 160 may be disposed in the first and second regions R1 and R2, respectively. For example, the first region R1 may be a region in which the pFET is disposed, and the second region R2 may be a region in which the nFET is disposed. In other embodiments, the first and second regions R1 and R2 can be regions where transistors with the same conductivity type and different electrical characteristics are disposed.

The first and second active regions 105A and 105B may include well regions including impurities, respectively. For example, in the first active region 105A of the first region R1 in which the pFET is disposed, the well region may include n-type impurities such as phosphorus (P), arsenic (As), or antimony (Sb). In the second active region 105B of the second region R2 in which the nFET is disposed, the well region may include p-type impurities such as boron (B), gallium (Ga), or aluminum (Al).

The inner spacer layers 130 may be disposed in the second region R2, and may be disposed on opposite side surfaces of the gate structure 160 under the fourth channel layer 144 in the X-direction. The description of the embodiment of FIG. 7B may be identically applied to the inner spacer layers 130.

The first and second source/drain regions 150A and 150B may have different inner structures. Aspects of the source/drain regions 150 as described with respect FIGS. 1 to 3 may be applied to the first source/drain regions 150A. In some embodiments, the first source/drain regions 150A may have a similar structure as the embodiments of FIGS. 4 to 7B.

Each of the second source/drain regions 150B may include first epitaxial layers 153 and second epitaxial layers 155. The first epitaxial layers 153 and the second epitaxial layer 155 may be semiconductor layers including the n-type impurities. The first epitaxial layers 153 may include upper layers 153T on side surfaces of each of the first to fourth channel layers 141, 142, 143 and 144, and a lower layer 153B on the upper surface of the active region 105. The upper layers 153T may be separated from each other between the first to fourth channel layers 141, 142, 143 and 144 in the Z-direction. The upper layers 153T may protrude toward the second epitaxial layer 155 based on an interface between the inner spacer layers 130 and the first to fourth channel layers 141, 142, 143 and 144. The first epitaxial layers 153 may be disposed not to overlap the inner spacer layers 130 in the Z-direction. The second epitaxial layer 155 may be disposed to fill the recessed region RC on the first epitaxial layers 153. The second epitaxial layer 155 may fill a gap between the upper layers 153T.

Both the first epitaxial layers 153 and the second epitaxial layer 155 may be semiconductor layers including silicon (Si), and may include different types and/or concentrations of impurities. For example, the first epitaxial layers 153 and the second epitaxial layer 155 may include arsenic (As) and/or phosphorus (P), and may be a SiAs layer, a SiP layer, a SiPC layer, a SiC layer, a SiPAs layer, or a SiGeP layer. For example, the first epitaxial layers 153 may be the SiAs layer, and the second epitaxial layer 155 may be the SiP layer.

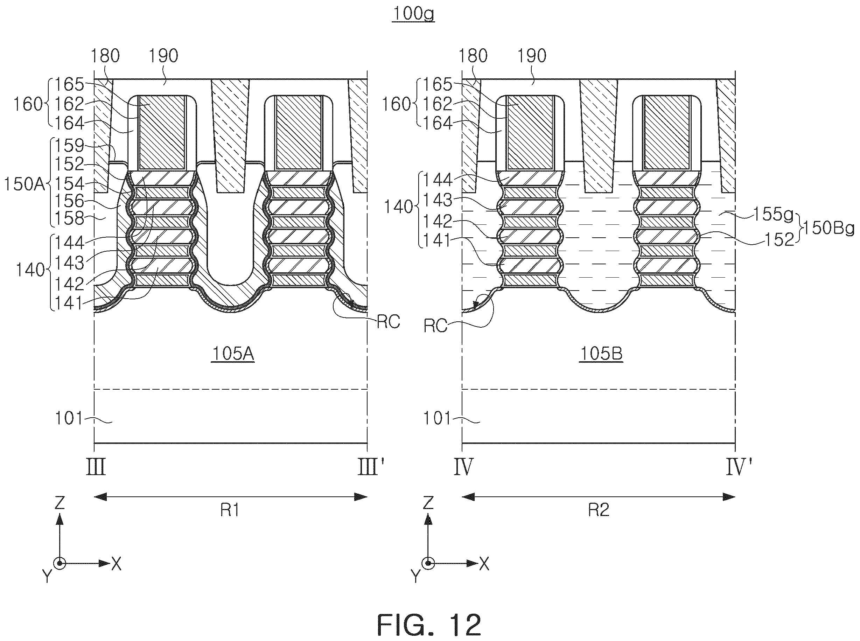

FIG. 12 is a cross-sectional view illustrating a semiconductor device according to example embodiments. FIG. 12 illustrates a region corresponding to FIG. 11.

Referring to FIG. 12, a semiconductor device 100g may include second source/drain regions 150Bg having a structure different from the embodiment of FIG. 11, and may not include inner spacer layers 130.

Each of the second source/drain regions 150Bg may include the first semiconductor layer 152 and a second epitaxial layer 155g. Similar aspects described with respect to FIGS. 1 to 3 may be applied to the first semiconductor layer 152. The second epitaxial layer 155g may be disposed on the first semiconductor layer 152 to fill the recessed region RC. Similar aspects of the second epitaxial layer 155 described with respect to FIG. 11 may be applied to other descriptions of the second epitaxial layer 155g. In some embodiments, each of the second source/drain regions 150Bg may further include the first epitaxial layers 153 of FIG. 11.

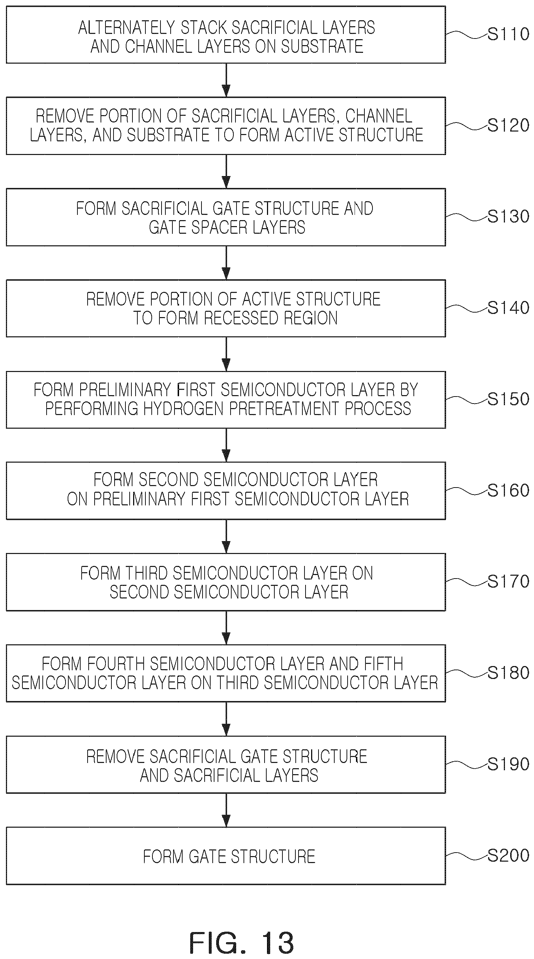

FIG. 13 is a flowchart illustrating a method for manufacturing a semiconductor device according to example embodiments.

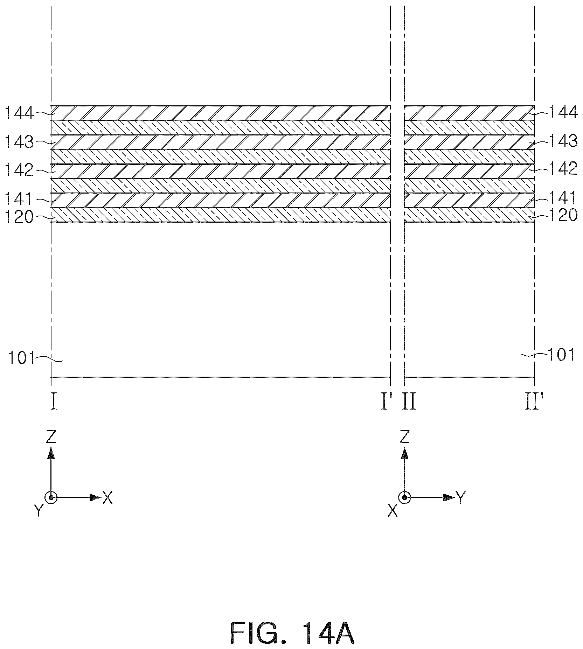

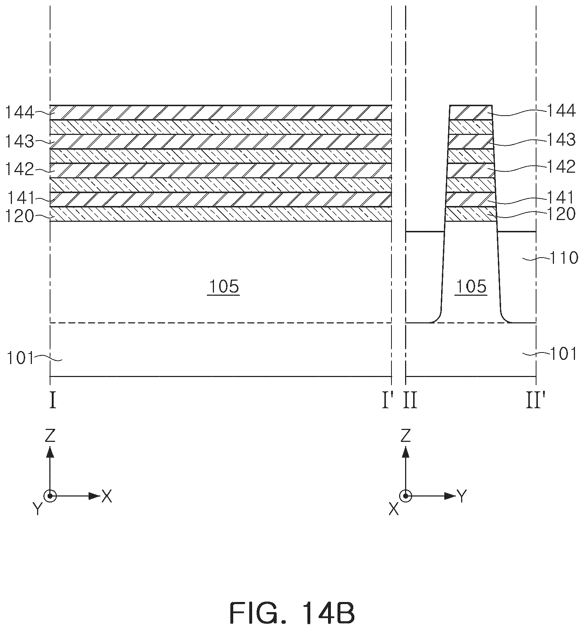

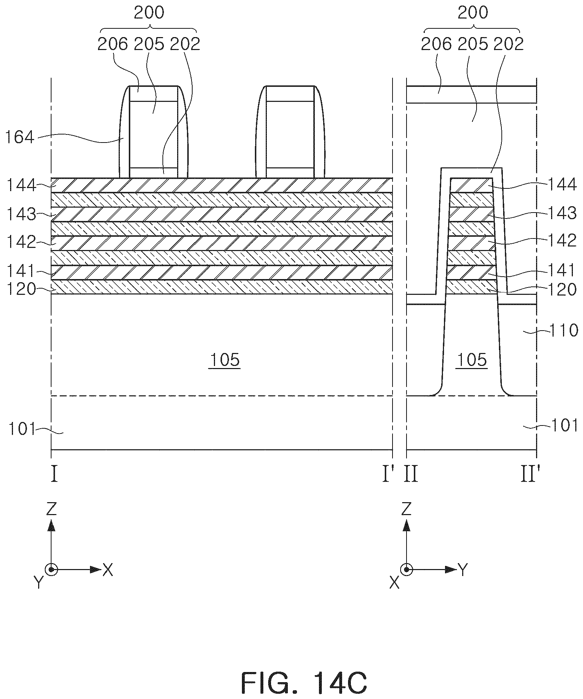

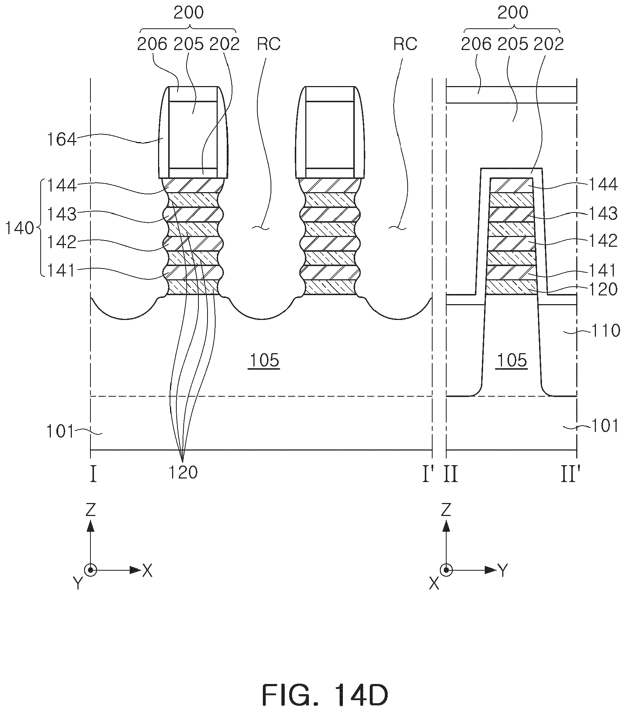

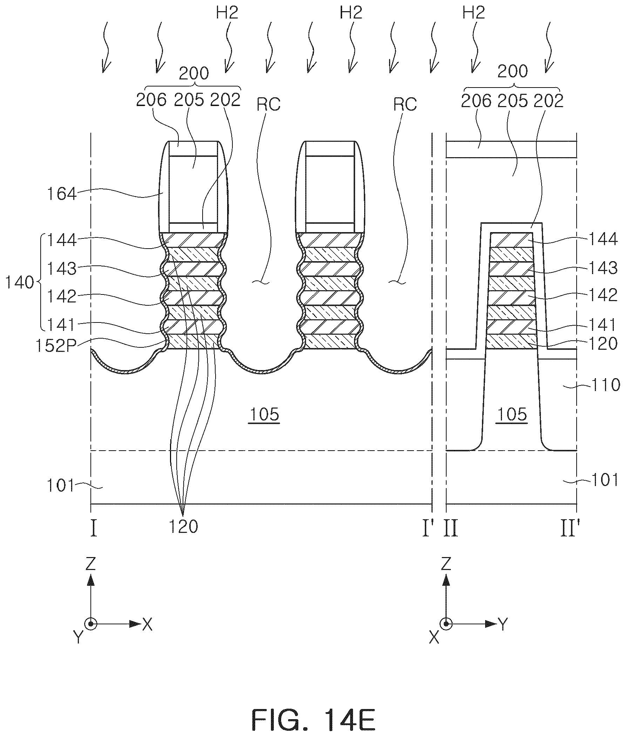

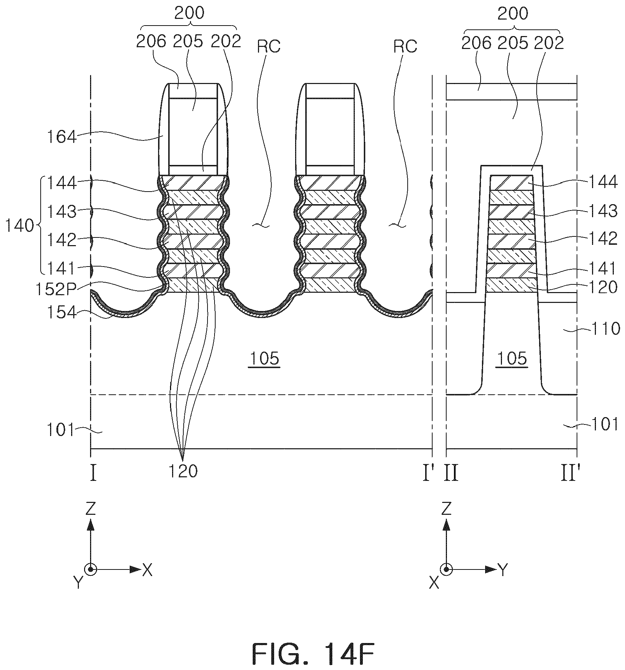

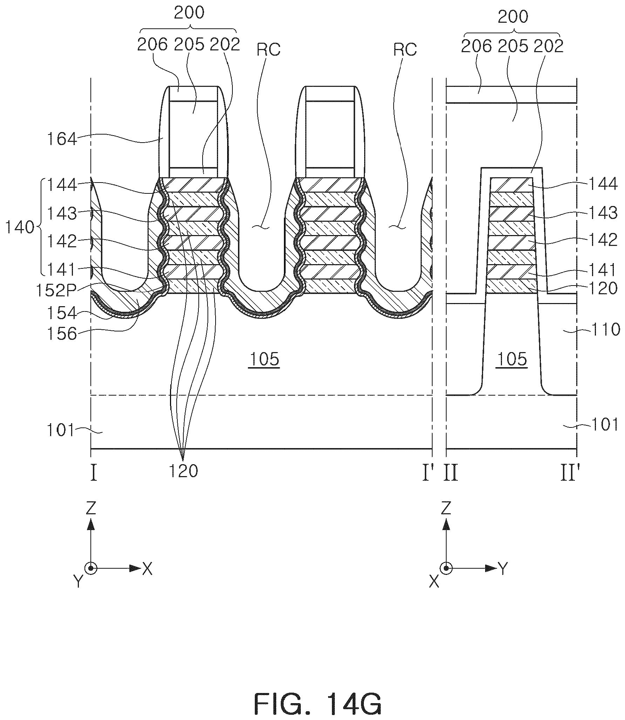

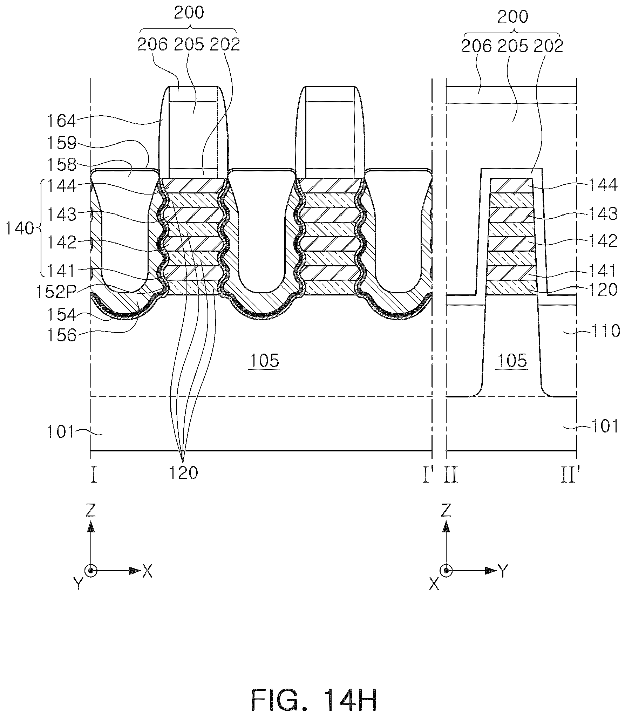

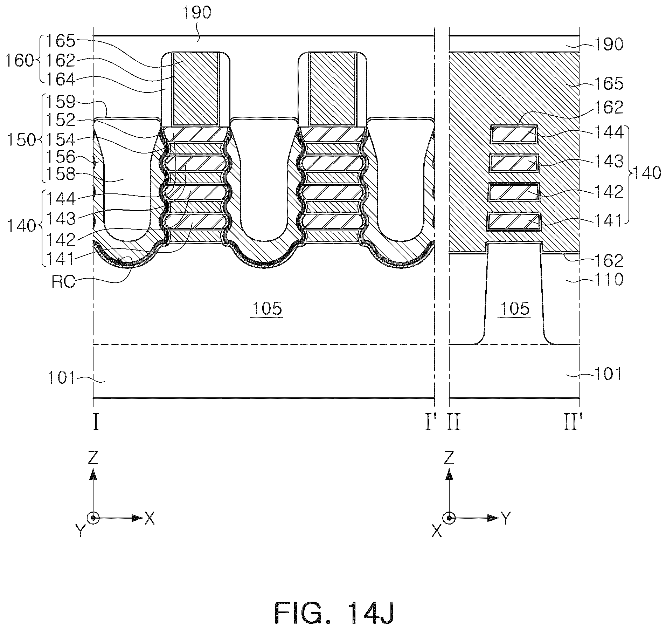

FIGS. 14A, 14B, 14C, 14D, 14E, 14F, 14G, 14H, 14I and 14J illustrate a method for manufacturing a semiconductor device according to a process sequence according to example embodiments. In FIGS. 14A to 14J, an example embodiment of a manufacturing method of the semiconductor device of FIG. 2 will be described.

Referring to FIGS. 13 and 14A, sacrificial layers 120 and first to fourth channel layers 141, 142, 143 and 144 may be alternately stacked on the substrate 101 in operation S110.

The sacrificial layers 120 may be a layer replaced with the gate dielectric layers 162 and the gate electrodes 165 under the fourth channel layer 144 through a subsequent process, as illustrated in FIG. 2. The sacrificial layers 120 may be formed of a material having etch selectivity with respect to the first to fourth channel layers 141, 142, 143 and 144, respectively. The first to fourth channel layers 141, 142, 143 and 144 may include a material different from the sacrificial layers 120. The sacrificial layers 120 and the first to fourth channel layers 141, 142, 143 and 144 may include, for example, a semiconductor material including at least one of silicon (Si), silicon germanium (SiGe), and germanium (Ge), but may include different materials, and may or may not include impurities. For example, the sacrificial layers 120 may include silicon germanium (SiGe), and the first to fourth channel layers 141, 142, 143 and 144 may include silicon (Si).

The sacrificial layers 120 and the first to fourth channel layers 141, 142, 143 and 144 may be formed by performing an epitaxial growth process from the stacked structure. The number of layers of channel layers alternately stacked with the sacrificial layers 120 may be variously changed in some embodiments.

Referring to FIGS. 13 and 14B, the sacrificial layers 120, the first to fourth channel layers 141, 142, 143 and 144, and the substrate 101 may be partially removed to form an active structure including the active region 105 in operation S 120. Furthermore, the device isolation layer 110 may be formed.

The active structure may include the active region 105, the sacrificial layers 120, and the first to fourth channel layers 141, 142, 143 and 144. The active structure may be formed in the form of a line extending in one direction (e.g., in the X-direction), and may be spaced apart from an adjacent active structure in the Y-direction. Side surfaces of the active structure in the Y-direction may be coplanar with each other and may be disposed on a straight line.

In a region from which each of the active region 105, the sacrificial layers 120, and the first to fourth channel layers 141, 142, 143 and 144 is partially removed. After the insulating material is embedded, a portion of the insulating material may be removed such that the active region 105 protrudes, thus forming the device isolation layer 110. The upper surface of the device isolation layer 110 may be formed lower than the upper surface of the active region 105.

Referring to FIGS. 13 and 14C, sacrificial gate structures 200 and gate spacer layers 164 may be formed on the active structure in operation S130.

Each of the sacrificial gate structures 200 may be a sacrificial structure formed in a region in which the gate dielectric layers 162 and the gate electrode 165 are disposed on the channel structure 140, as illustrated in FIG. 2 through a subsequent process. The sacrificial gate structures 200 may have a line shape intersecting the active structure and extending in one direction. The sacrificial gate structures 200 may extend, for example, in the Y-direction. Each of the sacrificial gate structures 200 may include first and second sacrificial gate layers 202 and 205 that are sequentially stacked and a mask pattern layer 206. The first and second sacrificial gate layers 202 and 205 may be patterned using the mask pattern layer 206.

The first and second sacrificial gate layers 202 and 205 may be, respectively, an insulating layer and a conductive layer, but the present disclosure is not limited thereto, and the first and second sacrificial gate layers 202 and 205 may be formed of a single layer. For example, the first sacrificial gate layer 202 may include silicon oxide, and the second sacrificial gate layer 205 may include polysilicon. The mask pattern layer 206 may include silicon oxide and/or silicon nitride.

The gate spacer layers 164 may be formed on opposite sidewalls of the sacrificial gate structures 200. The gate spacer layers 164 may be formed of a low dielectric constant material, and may include, for example, at least one of SiO, SiN, SiCN, SiOC, SiON, and SiOCN.

Referring to FIGS. 13 and 14D, the active structure exposed from the sacrificial gate structures 200 may be partially removed to form the recessed regions RC in operation S140. Furthermore, the sacrificial layers 120 may be partially removed.

Using the sacrificial gate structures 200 and the gate spacer layers 164 as masks, some of the exposed sacrificial layers 120 and some of the first to fourth channel layers 141, 142, 143 and 144 may be removed to form the recessed regions RC. Accordingly, the first to fourth channel layers 141, 142, 143 and 144 may form the channel structures 140 with a limited length in the X-direction.

The sacrificial layers 120 may be selectively etched with respect to the channel structures 140 by, for example, a wet etching process and removed to a predetermined depth from the side surface in the X-direction. The sacrificial layers 120 may have inwardly concave side surfaces by side-surface etching as described above. The channel structures 140 may also have outwardly convex side surfaces by the present process. However, the specific shapes of the side surfaces of the sacrificial layers 120 and the channel structures 140 are not limited to those illustrated in FIG. 14D.

Referring to FIGS. 13 and 14E, a preliminary first semiconductor layer 152P of the source/drain regions 150 (see FIG. 2) may be formed in the recessed regions RC by performing a hydrogen (H₂) pretreatment process in operation S150.

The hydrogen (H₂) pretreatment process may be a baking process for a surface treatment of the recessed regions RC. The hydrogen (H₂) pretreatment process may be performed at high temperatures ranging from about 600°C to about 850°C so as to remove the impurities in the recessed regions (RC). During the process, germanium (Ge) may be migrated in the channel structures 140 such that the preliminary first semiconductor layer 152P, which is a silicon germanium (SiGe) layer with a lower concentration than the channel structures 140, may be formed in a band shape. For example, the concentration of germanium (Ge) in the channel structures 140 may range from about 25% to about 40%, and the concentration of germanium (Ge) in the preliminary first semiconductor layer 152P may range from about 1% to about 15% (e.g., from about 7% to about 13%). The preliminary first semiconductor layer 152P may be conformally formed along the inner surfaces of the recessed regions RC.

Referring to FIGS. 13 and 14F, the second semiconductor layer 154 may be formed on the preliminary first semiconductor layer 152P in operation S160.

The second semiconductor layer 154 may be grown and formed by, for example, a selective epitaxial process. The second semiconductor layer 154 may include impurities by in-situ doping or ex-situ doping. For example, the second semiconductor layer 154 may be a SiB layer. The second semiconductor layer 154 may be conformally formed along the preliminary first semiconductor layer 152P.

Referring to FIGS. 13 and 14G, the third semiconductor layer 156 may be formed on the second semiconductor layer 154 in operation S170.

The third semiconductor layer 156 may be grown and formed by, for example, the selective epitaxial process, similarly to the second semiconductor layer 154 described above. The third semiconductor layer 156 may be a silicon germanium (SiGe) layer, and may have a lower concentration of germanium (Ge) than that of the preliminary first semiconductor layer 152P. The third semiconductor layer 156 may be formed relatively thicker than the preliminary first semiconductor layer 152P and the second semiconductor layer 154. Accordingly, the outer surface of the third semiconductor layer 156 may have a curve, but the inner surface thereof may have a relaxed curve or have no curve

Referring to FIGS. 13 and 14H, the fourth semiconductor layer 158 and the fifth semiconductor layer 159 may be formed on the third semiconductor layer 156 in operation S180.

The fourth semiconductor layer 158 and the fifth semiconductor layer 159 may be grown and formed by, for example, the selective epitaxial process, similarly to the second semiconductor layer 154 described above. The fourth semiconductor layer 158 may be formed to fill the recessed regions RC, and the fifth semiconductor layer 159 may be formed on the upper surface of the fourth semiconductor layer 158 and may be formed on the recessed regions RC. The fourth semiconductor layer 158 may have a higher concentration of germanium (Ge) than that of the germanium (Ge) of the third semiconductor layer 156. The fifth semiconductor layer 159 may have a lower concentration of germanium (Ge) than that of the fourth semiconductor layer 158. The fifth semiconductor layer 159 may be, for example, a silicon (Si) layer, but the present disclosure is not limited thereto.

Referring to FIGS. 13 and 14I, the interlayer insulating layer 190 may be formed, and the sacrificial gate structures 200 and the sacrificial layers 120 may be removed in operation S190.

The interlayer insulating layer 190 may be formed by forming an insulating layer covering (or at least partially covering) the sacrificial gate structures 200 and the source/drain regions 150 and performing a planarization process to expose the mask pattern layers 206.

The sacrificial gate structures 200 and the sacrificial layers 120 may be selectively removed from the gate spacer layers 164, the interlayer insulating layer 190, and the channel structures 140. First, the sacrificial gate structures 200 may be removed to form upper gap regions UR, and then the sacrificial layers 120 exposed through the upper gap regions UR may be removed to form lower gap regions LR.

When the sacrificial layers 120 include silicon germanium (SiGe) and the channel structures 140 include silicon (Si), the sacrificial layers 120 may be selectively removed from the channel structures 140 by performing the wet etching process. When the sacrificial layers 120 include a relatively high concentration of germanium (Ge) and the second semiconductor layer 154 includes a relatively low concentration of germanium (Ge), the sacrificial layers 120 may be selectively removed from the second semiconductor layer 154. The preliminary first semiconductor layer 152P may include, for example, the third concentration of germanium (Ge) between the first concentration and the second concentration, and in this step, a portion of the regions exposed after removing the sacrificial layers 120 may be removed to form a plurality of first semiconductor layers 152. Even if the exposed preliminary first semiconductor layer 152P is removed, the second semiconductor layer 154 may have large etching selectivity, thereby preventing the third semiconductor layer 156, the fourth semiconductor layer 158, and the fifth semiconductor layer 159 from being damaged.

In the example embodiments of FIGS. 5 to 7a, a difference between the third concentration of the preliminary first semiconductor layer 152P and the first concentration of the sacrificial layers 120 may be relatively large. Accordingly, in this case, since the preliminary first semiconductor layer 152P may remain without being removed, the first semiconductor layers 152b and 152c, which are single layers, may be formed. In the case of the embodiment of FIG. 7B, the preliminary first semiconductor layer 152P may not be exposed by the inner spacer layers 130 during the manufacturing process. Accordingly, since the preliminary first semiconductor layer 152P may remain without being removed, one first semiconductor layer 152d may be formed.

Referring to FIGS. 13 and 14J, the gate structures 160 may be formed in operation S200.

The gate structures 160 may be formed to fill the upper gap regions UR and the lower gap regions LR. The gate dielectric layers 162 may be formed to conformally cover inner surfaces of the upper gap regions UR and the lower gap regions LR. The gate electrode 165 may be formed to fill (e.g., completely fill) the upper gap regions UR and the lower gap regions LR, and then may be removed by a predetermined depth from the top in the upper gap regions UR together with the gate dielectric layers 162 and the gate spacer layers 164. Accordingly, gate structures 160 including each of the gate dielectric layers 162, the gate electrode 165, and the gate spacer layers 164 may be formed.

After the gate structure 160 is formed, the interlayer insulating layer 190 may be further formed on the gate structure 160.

Referring to FIG. 2 together, the contact plugs 180 may be formed.

Contact holes exposing the source/drain regions 150 may be formed by patterning the interlayer insulating layer 190. Next, the contact plugs 180 may be formed by filling the contact holes with a conductive material.

Specifically, after a material forming the barrier layer is deposited in the contact holes, a silicide process may be performed to form a metal-semiconductor compound layer, such as a silicide layer, in a lower end thereof. The conductive material may be deposited to fill the contact holes to form the contact plugs 180. Accordingly, the semiconductor device 100 of FIGS. 1 to 3 may be manufactured.

Referring to FIGS. 1, 2 and 3, in accordance with example embodiments, a structure in which a first semiconductor layer 152 and a second semiconductor layer 154 are formed on an external side of a third semiconductor layer 156 is provided. The second semiconductor layer 154 may be formed of a silicon layer to secure an etch selectivity, thereby protecting the third semiconductor layer 156. The first semiconductor layer 152 may be formed during a pretreatment process of the recess region RC. Because the second semiconductor layer 154 is formed, the first semiconductor layer 152 may be recognized separately from (i.e., be distinguished from) the third semiconductor layer 156.

Each of the embodiments provided in the above description is not excluded from being associated with one or more features of another example or another embodiment also provided herein or not provided herein but consistent with the disclosure

While the disclosure has been particularly shown and described with reference to embodiments thereof, it will be understood that various changes in form and details may be made therein without departing from the scope of the following claims.

## Claims

1. A semiconductor device, comprising:
a substrate (101) comprising an active region (105) extending in a first direction (X);
a gate structure (160) intersecting the active region (105) on the substrate (101) and extending in a second direction (Y), wherein the active region (105) comprises a recessed region (RC) at at least one side of the gate structure (160);
a plurality of channel layers (141, 142, 143, 144) on the active region (105), spaced apart from each other in a third direction (Z) that is substantially perpendicular to an upper surface of the substrate (101), and at least partially surrounded by the gate structure (160); and
a source/drain region (150) in the recessed region (RC) of the active region (105) and connected to the plurality of channel layers (141, 142, 143, 144),
wherein the source/drain region (150) comprises:
at least one first semiconductor layer (152; 152a; 152b; 152c; 152d) on the active region (105) and on side surfaces of the plurality of channel layers (141, 142, 143, 144) that are exposed through the recessed region (RC);
a second semiconductor layer (154) extending continuously while being provided on at least one of the at least one first semiconductor layer (152; 152a; 152b; 152c; 152d) and side surfaces of the gate structure (160); and
a third semiconductor layer (156) on the second semiconductor layer (154),
wherein the at least one first semiconductor layer (152; 152a; 152b; 152c; 152d) comprises a first concentration of germanium, Ge, and
wherein the third semiconductor layer (156) comprises a second concentration of germanium, Ge, that is smaller than the first concentration of germanium, Ge.

2. The semiconductor device of claim 1, wherein the at least one first semiconductor layer (152; 152a) comprises a plurality of first semiconductor layers (152; 152a), the plurality of first semiconductor layers (152; 152a) being spaced apart from each other.

3. The semiconductor device of claim 1 or 2, wherein the second semiconductor layer (154) comprises a third concentration of germanium, Ge, that is smaller than the second concentration of germanium, Ge.

4. The semiconductor device of any one of claims 1 to 3, wherein the first concentration of germanium, Ge, is in a range of about 1% to about 15%.

5. The semiconductor device of any one of claims 1 to 4, wherein the at least one first semiconductor layer (152; 152b; 152d) has a substantially conformal thickness (T1, T2).

6. The semiconductor device of any one of claims 1 to 5, wherein the at least one first semiconductor layer (152a; 152c) has a first thickness (T 1) on the side surfaces of the plurality of channel layers (141, 142, 143, 144) and a second thickness (T2') larger than the first thickness (T1) on the active region (105).

7. The semiconductor device of any one of claims 1 to 6, wherein the at least one first semiconductor layer (152; 152a; 152b; 152c; 152d) has a thickness (T1, T2) of about 0.1 nm to about 3 nm.

8. The semiconductor device of any one of claims 1 to 7, wherein, in a cross section along the first direction (X), at least some ends of the at least one first semiconductor layer (152; 152a; 152b; 152c) are shifted from each other such that, in the third direction (Z), the at least some ends are disposed in a non-straight line.

9. The semiconductor device of any one of claims 1 to 8, wherein the second semiconductor layer (154) contacts the gate structure (160) between the plurality of channel layers (141, 142, 143, 144).

10. The semiconductor device of any one of claims 1 to 9, wherein the second semiconductor layer (154) comprises a silicon layer.

11. The semiconductor device of any one of claims 1 to 10, wherein the second semiconductor layer (154) comprises a plurality of regions protruding convexly toward the side surfaces of the gate structure (160).

12. The semiconductor device of any one of claims 1 to 11, wherein the at least one first semiconductor layer (152; 152a; 152b; 152c; 152d), the second semiconductor layer (154), and the third semiconductor layer (156) further comprise impurities comprising at least one of boron, gallium, and indium.

13. The semiconductor device of any one of claims 1 to 12, wherein the source/drain region (150) further comprises a fourth semiconductor layer (158) filling the recessed region (RC) on the third semiconductor layer (156).

14. The semiconductor device of claim 13, wherein a fourth concentration of germanium, Ge, of the fourth semiconductor layer (158) is greater than the second concentration of germanium, Ge.

15. The semiconductor device of claim 13 or 14, wherein the source/drain region (150) further comprises a fifth semiconductor layer (159) on an upper surface of the fourth semiconductor layer (158) and comprising a fifth concentration of germanium, Ge, that is smaller than the second concentration of germanium, Ge,.
